Europäisches Patentamt

European Patent Office

Office européen des brevets

(19)

(11) Veröffentlichungsnummer : **0 018 500**
**B1**

(12) **EUROPÄISCHE PATENTSCHRIFT**

(45) Veröffentlichungstag der Patentschrift :
05.10.83

(51) Int. Cl.³ : **C 25 D 5/02**

(21) Anmeldenummer : **80101626.2**

(22) Anmeldetag : **27.03.80**

(54) Galvanisierverfahren mit selektiver Steigerung der Niederschlagsrate.

(30) Priorität : **08.05.79 US 37075**

(43) Veröffentlichungstag der Anmeldung :
**12.11.80 Patentblatt 80/23**

(45) Bekanntmachung des Hinweises auf die Patenterteilung : **05.10.83 Patentblatt 83/40**

(84) Benannte Vertragsstaaten :
**BE CH DE FR GB NL SE**

(56) Entgegenhaltungen :
**FR A 2 245 784**
**FR A 2 333 876**
**US A 2 744 859**
**US A 3 506 545**

(73) Patentinhaber : **International Business Machines Corporation**
**Old Orchard Road**
**Armonk, N.Y. 10504 (US)**

(72) Erfinder : **Melcher, Robert Lee**
**2339 Vista Court**
**Yorktown Heights, N.Y. 10598 (US)**
Erfinder : **von Gutfeld, Robert Jacob**
**600 West 115th Street**
**N.Y. 10025 (US)**

(74) Vertreter : **Schröder, Otto H., Dr.-Ing.**
**c/o International Business Machines Corporation**
**Zurich Paten'. Operations Säumerstrasse 4**
**CH-8803 Rüschlikon/ZH (CH)**

Jouve, 18, rue St-Denis, 75001 Paris, France

## Galvanisierverfahren mit selektiver Steigerung der Niederschlagsrate

Die Erfindung betrifft ein Galvanisierverfahren mit selektiver Steigerung der Niederschlagsrate in ausgewählten Gebieten der Oberfläche einer Kathode. Insbesondere betrifft sie ein maskenloses Verfahren, um Leitungszüge hoher Auflösung auf einem Substrat herzustellen.

Klassische Verfahren des Plattierens in bevorzugten Gebieten erfordern eine Anzahl von Verfahrensschritten. Zuerst muss die zu plattierende Oberfläche mit einer Maske versehen werden, anschliessend wird sie an den nicht bedeckten Stellen galvanisiert und schliesslich muss die Maske wieder entfernt werden. Diese mehrfachen Verfahrensschritte sind zeitraubend und tragen zur Erhöhung der Kosten für das Verfahren bei.

Auf einen Photoleiter können beliebige Muster plattiert werden, indem man ihn selektiv belichtet. In der US Patentschrift 3 013 955 ist beschrieben, wie man dotierte Gebiete von Silicium dem Licht aussetzt und dadurch einen Photoeffekt bewirkt, der seinerseits die Erzeugung von Niederschlägen begünstigt in den dotierten Gebieten, welche dem Licht ausgesetzt waren.

Die US Patentschriften 3 345 274 und 3 345 275 lehren die Anodisierung oder Eloxierung eines photoleitenden Substrates zu verbessern, indem man solche Gebiete belichtet, welche anodisiert werden sollen.

Diese Patentschriften lehren Verfahren für die Herstellung von bevorzugten oder selektiven Mustern von Niederschlägen auf Substraten, indem man diese Substrate oder Teile davon dem Licht aussetzt. Die Anwendung solcher Verfahren ist jedoch auf photoleitende Substrate begrenzt. Sie lehren in keiner Weise die Steigerung der Niederschlagsrate als eine Funktion der Lichtstärke oder der Stärke der Lichtquelle.

Das Verfahren nach der US Patentschrift 3 506 545 erfordert kein photoleitendes Substrat. Die technische Lehre besteht darin, die zu plattierenden Gebiete vorher lokal einer Wärmebehandlung zu unterwerfen und dies mit einem Laser auszuführen. Die so behandelten Gebiete werden in ihrer Leitfähigkeit verbessert, wodurch auch die Niederschlagsrate verbessert wird. Nach der Patentschrift soll dieses Verfahren auf amorphe halbleitende Substrate angewendet werden, welche durch die Wärmebehandlung kristallin werden. Obwohl bei diesem Verfahren die Notwendigkeit entfällt, dass das Substrat photoleitend sein soll, so ist es doch von begrenzter Brauchbarkeit, weil es ein Substrat verlangt, welches der Wärmebehandlung ausgesetzt werden kann und dessen Leitfähigkeit durch diese Behandlung besser wird.

K. Walker, und C. T. Walker haben in einem Artikel mit dem Titel « New Explanations for Brightness of Electro-Deposits by Ultrasound » auf den Seiten 79 bis 82 von Ultrasonics, März 1975, berichtet, dass ein beachtlicher Anstieg der Stromdichte beobachtet wurde, wenn eine Erregung durch Ultraschall stattfand, wobei auch die Niederschlagsrate verbessert wurde.

M. P. Drake erklärt in einem Abstrakt für einen Vortrag vor der Electrochemical Society, Abstract No. 161, Band 78-2, Seite 434, (1978), Pittsburgh, Pa., dass eine dreifache Verbesserung der Niederschlagsrate von Gold erhalten werden kann, wenn man das Substrat Ultraschall aussetzt, wobei die aufgebrachte Leistung etwa 4 W/cm$^2$ ist. Obwohl dieses Verfahren eine lokal bevorzugte Plattierung erzeugt, so ist trotzdem das Verhältnis zwischen der bevorzugten Plattierung und der Hintergrundplattierung nur der Faktor 3, was nicht ausreicht, um ohne Anwendung einer Maske Leitungsmuster guter Auflösung zu erzeugen.

A. A. Wragg und A. K. Nasiruddin berichten in Electrochimica Acta, Band 118, Seite 619 (1973), dass das Aufheizen eines Substrats auf 91 °C eine Verbesserung des plattierten Gebietes um etwa das Siebenfache erbringt und dass bis zum Einsetzen der Verdampfung der Faktor auf 50 wächst. Das Heizen der Kathode würde bevorzugtes Niederschlagen erzeugen, aber es würde den gleichen Begrenzungen unterliegen, wie sie in der oben angeführten Arbeit von Drake diskutiert sind.

B. L. Bestel und Mitarbeiter erklären in einem Abstrakt der Electrochemical Society, Abstract 286, Band 77, No. 2, Seite 759 (1977), dass auf eine Kathode auch Muster elektroplattiert werden können nach einem Düsenstrahlverfahren. Nach dem Verfahren fällt auf eine Kathode ein Strahl ein, der gleichzeitig als Anode dient. Das Verfahren erfordert daher eine spezielle Ausrüstung. Auch ist seine auflösung begrenzt durch den Durchmesser des Strahles, der in der Grössenordnung von 0,013 mm liegt. Eine bessere Auflösung ist möglich, jedoch wird es schwierig, die Düsen für solch feinere Strahlen herzustellen. Auch besteht die Tendenz zur Verstopfung der Düsen im Gebrauch. Schliesslich besteht eine Begrenzung darin, dass es schwierig ist, mit einem Strahl eine Oberfläche so abzutasten, dass ein sauberes Leitungsmuster erzeugt wird.

Es ist eine Aufgabe der Erfindung, ein Verfahren zum selektiven Galvanisieren elektrisch leitender Oberflächen anzugeben, das die Anwendung einer Maske überflüssig macht. Eine weitere Aufgabe der Erfindung besteht darin, ein Verfahren zur selektiven Steigerung der Niederschlagsrate beim Galvanisieren anzugeben. Ein weiteres Ziel der Erfindung besteht darin, ein Verfahren zur selektiven Galvanisierung anzugeben, das geeignet ist, Aenderungen oder Reparaturen an integrierten Schaltungen auf dem Chip selbst auszuführen.

Das Galvanisierverfahren mit selektiver Steigerung der Niederschlagsrate in ausgewählten Gebieten der Oberfläche einer Kathode besteht darin, dass man die Kathode in einen Elektrolyten einbringt, der sich unter dem Einfluss von Strahlung nicht zersetzt, dass man gebündelte elektromagnetische Strahlung auf die ausgewählten Gebiete der Oberfläche der Kathode richtet, wobei diejenigen Gebiete selektiv aufgeheizt werden, welche bevorzugt plattiert werden sollen, das man eine getrennte Anode im Elektrolyten vorsieht, und dass man zwischen der Anode und der Kathode eine elektrische Spannung anlegt, während die Kathodenoberfläche durch die genannte Strahlung lokal aufgeheizt wird.

Vorteile und Anwendungen der Erfindung gehen aus der folgenden Beschreibung von Ausführungsbeispielen hervor, die mit Hilfe der Zeichnungen näher beschrieben werden.

Figur 1 ist ein erstes Ausführungsbeispiel der Erfindung, das eine Form des Verfahrens illustriert, wobei ein Strahl elektromagnetischer Energie auf die Stelle der Oberfläche gerichtet wird, wo eine bevorzugte Ablagerung stattfinden soll.

Figur 2 ist ein zweites Ausführungsbeispiel der Erfindung, das eine Form des Verfahrens illustriert, wobei ein Strahl elektromagnetischer Energie auf die Rückseite des Substrates gerichet wird, wodurch auf der Vorderseite ein Gebiet der Oberfläche selektiv aufgeheizt wird, was bevorzugt plattiert werden soll.

Das erfindungsgemässe Verfahren erlaubt das bevorzugte Galvanisieren von Gebieten einer Kathode, wobei die Hintergrundplattierung in benachbarten Gebieten weitgehend unterdrückt wird. Eine Kathode wird in eine Lösung eingebracht, die ein Elektrolyt ist. Vorzugsweise besteht die Kathode aus einem nichtleitenden Substrat, das möglichst auch nicht-wärmeleitend ist und dessen Oberfläche mit einer dünnen Metallschichtauflage elektrisch leitend gemacht wurde. Im Abstand von der Kathode wird in den Elektrolyten eine Anode eingebracht.

Der scharf gebündelte Strahl einer Energiequelle wird auf Gebiete der Oberfläche der Kathode gerichtet, wodurch eine lokale Aufheizung erfolgt. Durch das Anlegen einer elektrischen Spannung zwischen der positiven Anode und der negativen Kathode wird ein Elektrolysenbad für das Galvanisieren eingerichtet. In dem lokal aufgeheizten Gebiet ist die Niederschlagsrate wesentlich gesteigert im Vergleich zu der Rate der Hintergrundplattierung in den Gebieten, die nicht aufgeheizt sind.

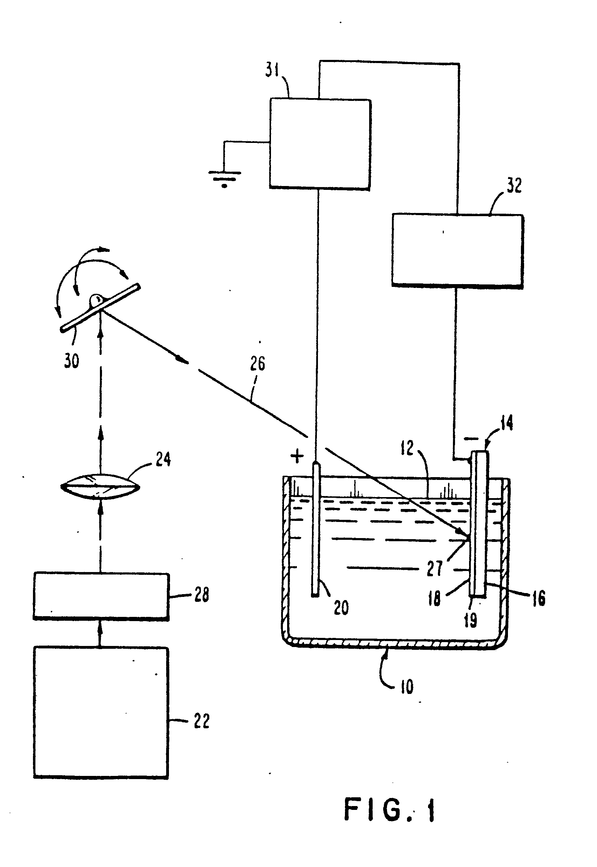

In der Fig. 1 enthält ein Gefäss 10 einen Elektrolyten 12. Eine Kathode 14 ist in den Elektrolyten 12 eingetaucht. Die Kathode 14 mag aus einem Metall oder einem Photoleiter bestehen, sie kann aber auch zusammengesetzter Struktur sein, bestehend aus einem Isolator und einem elektrischen Leiter.

Wenn die Kathode 14 von zusammengesetzter Struktur ist, besitzt sie beispielsweise ein nichtwärmeleitendes Substrat 16. Dieses Substrat mag aus einem Material wie Glas oder aus einem anderen Dielektrikum bestehen. Das isolierende Substrat 16 wird an seiner Oberfläche 18 durch die Auflage einer dünnen metallischen Schicht 19 elektrisch leitend gemacht. Zu diesem Zweck verwendet man Metalle wie Wolfram, Molybdän, Nickel oder Kupfer. Die Dicke der aufgebrachten Metallschicht 19 liegt etwa zwischen 300 Å und 10 000 Å. Der untere Grenzwert ist ausreichend um adäquate elektrische Leitfähigkeit zu gewährleisten, während der obere Grenzwert noch eine ausreichende Wärmeleitung bietet, die aber begrenzt ist, um eine unangemessene Ausbreitung der Wärme ausserhalb der lokal aufgeheizten Gebiete zu verhindern.

Im Abstand von der Kathode 14 ist in den Elektrolyten 12 eine Anode 20 eingebracht. Die Anode besteht aus irgend einem geeignetem Material wie Platin, Palladium, einem anderen Edelmetall oder aus Edelmetallegierungen. Ein Strahl 26 von einer Strahlungsquelle 22 wird durch ein Linsensystem 24 so in den Elektrolyten 12 gerichtet, dass er auf die Metallschicht 19 der Kathode 14 einfällt. Die Wellenlänge der elektromagnetischen Strahlung des sichtbaren Bereiches oder aus dem infraroten Spektrum wird so ausgewählt, dass die Strahlung möglichst wenig durch den Elektrolyten 12 absorbiert wird, aber möglichst stark durch die Kathode 14. Die Strahlung wird beispielsweise durch das Linsensystem 24 so gebündelt, dass der Strahl 26 ein Gebiet 27 der Metallschicht 19 auf der Vorderfläche 18 der Kathode 14 stark beleuchtet. Der Strahl 26 kann durch einen Abtastspiegel 30 bewegt und so verändert werden, dass er einen bestimmten Bereich der Kathode 14 überstreicht. Für den gleichen Effekt kann man selbstverständlich auch einen stationären Strahl 26 verwenden und die Kathode 14 entsprechend bewegen, damit ein vorbestimmtes Gebiet der Kathode aufgeheizt wird.

Wenn elektromagnetische Strahlung aus dem sichtbaren Bereich verwendet wird, kann sie beispielsweise durch einen Kohlelichtbogen erzeugt werden. Vorzugsweise verwendet man aber einen Laser wie beispielsweise einen breitbandigen Multimodenlaser oder einen Argonlaser, der nur in einem Modus arbeitet. Oder man verwendet einen abstimmbaren Kryptonlaser. Der Laser stellt eine Strahlungsquelle 22 hoher Intensität dar. In diesem Falle kann sogar auf das Linsensystem 24 verzichtet werden, falls nicht eine besondere Konzentration des Strahles auf das Gebiet 27 notwendig ist. Vorzugsweise sollte die Intensität der Strahlungsquelle ausreichend sein, um einen Strahl 26 mit einer Intensität im Bereich zwischen $10^2$ und $10^6$ W/cm$^2$ bereitzustellen.

Der untere Grenzwert ermöglicht noch eine Steigerung der Niederschlagsrate. In diesem Zusammenhang muss darauf aufmerksam gemacht werden, dass diese Intensität immer noch erheblich über den Werten liegt, wie man sie braucht, um Photoleiter zu sensibilisieren. Deshalb unterscheidet sich die vorliegende Erfindung klar von der technischen Lehre, wie sie aus den US Patentschriften 3 013 955, 3 345 274 und 3 345 275 hervorgeht.

Der obere Grenzwert sollte so gewählt werden, dass man thermisch bedingte Strukturveränderungen der Kathode 14 vermeidet. Im allgemeinen wird die maximale eingestrahlte Leistung auf etwa $10^6$ W/cm$^2$ für Belichtungen länger als Mikrosekunden begrenzt sein und sie mag entsprechend höher sein für kürzere Impulsdauern.

Wenn der Lichtstrahl 26 den Elektrolyten 12 durchläuft, dann muss man darauf achten, dass die Wellenlänge des Lichtes so gewählt ist, dass starke Absorption durch den Elektrolyten 12 vermieden wird. Wenn beispielsweise als Elektrolyt Lösungen von Nickelsalzen oder Kupfersalzen verwendet werden, dann ist das Spektrum eines Argonlasers geeignet. Im Falle des Niederschlages von Gold wird zweckmässig ein Kryptonlaser verwendet, der auf 6 471 Å abgestimmt wird, damit der Lichtstrahl 26 durch den Elektrolyten 12 nicht stark absorbiert wird.

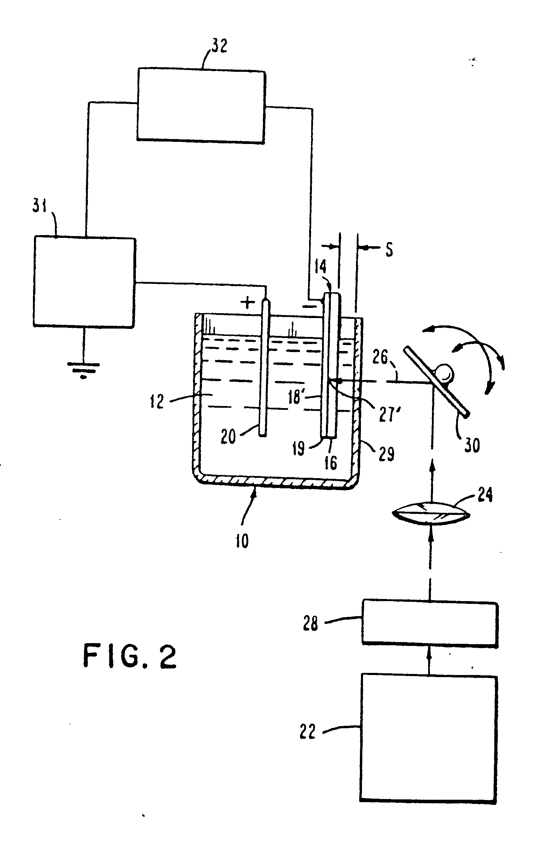

Das Verfahren kann aber auch so eingerichtet werden, dass der Lichtstrahl 26 nicht grössere Strecken durch den Elektrolyten 12 durchlaufen muss. In diesem Falle hat die Absorption des Elektrolyten weniger Einfluss. Ein Beispiel ist in der Fig. 2 dargestellt. In diesem Falle wird das Gefäss 10 und das Substrat 16 so ausgesucht, dass mindestens eine Wand 29 für den einfallenden Strahl 26 transparent ist. Der Strahl 26 durchläuft die Wand 29 des Gefässes und von hinten her kommend das Substrat 16, um auf die Metallschicht 19 einzufallen, welche das Licht absorbiert. Man macht in diesem Falle den Raum S zwischen der Kathode 14 und der Wand 29 des Gefässes 10 so klein wie möglich, damit nur wenig Flüssigkeit oder gar kein Elektrolyt vorhanden ist, der von dem Strahl 26 durchlaufen werden muss. Im übrigen entspricht die Fig. 2 in grossen Zügen der Fig. 1, weshalb gleichartige Elemente mit gleichen Bezugszeichen versehen sind.

Der Strahl 26 der Strahlungsquelle 22 kann durch einen Modulator 28 moduliert oder periodisch unterbrochen werden, der sich entweder zwischen der Strahlungsquelle 22 und dem Linsensystem 24 oder zwischen dem Linsensystem 24 und der Kathode 14 im Strahlengang befindet. Der Modulator 28 kann ein mechanischer Zerhacker sein, wenn die Modulationsfrequenz niedrig ist, oder ein optischer Modulator, wenn eine höhere Frequenz benutzt wird.

Ein Spannungsquelle 31 ist zwischen die Anode 20 und die Kathode 14 so geschaltet, dass die Kathode 14 ein negatives Potential gegenüber der positiven Anode 20 annimmt. Ein Modulator 32 kann vorgesehen sein, um die durch die Spannungsquelle 31 gelieferte Spannung und damit den Galvanisierstrom modulieren zu können. Diese elektrische Modulation kann auf die optische Modulation abgestimmt sein oder mit dieser synchronisiert werden.

Wenn die Spannung wie beschrieben angelegt wird, dann wandern die Metallionen zur Kathode 14, werden dort mit Elektronen neutralisiert und als Metall niedergeschlagen. Während auf der Vorderseite 18' der Kathode 14 ein allgemeiner Niederschlag von Metallionen erfolgt, der eine Hintergrundplattierung bewirkt, erfolgt bevorzugte Plattierung in solchen Gebieten, wo die Strahlung einfällt. Eine Modulierung oder periodische Unterbrechung der Strahlung gibt Anlass zu schärferen Temperaturprofilen an den Begrenzungen der Gebiete vorzugsweiser Plattierung 27', wodurch die Auflösung zwischen solchen Gebieten vorzugsweiser Plattierung 27' und der Hintergrundplattierung verbessert wird.

Die Modulation der Laserstrahlung hat einen begrenzenden Effekt auf die Ausbreitung der Wärme, welche infolge Wärmeleitung im Substrat auftritt und die Auflösung verschlechtert. Die Synchronisation des Laserlichtes mit der Galvanisierspannung hat den Vorteil, dass der Niederschlag nur erfolgen darf, wenn der Laser das Substrat lokal aufgeheizt hat und so einen optimalen Temperaturgradienten hervorruft. In den übrigen Zeiten des Modulationszyklus ist die Galvanisierspannung abgeschaltet, wodurch eine Hintergrundplattierung weitgehend vermieden wird.

In den der Strahlung ausgesetzten Gebieten kann die Niederschlagsrate bis etwa $10^3 \times$ grösser sein als in den Gebieten der Hintergrundplattierung, wo keine Strahlung einfällt. Nach Fertigstellung der Plattierung entfernt ein mildes Aetzen die Hintergrundplattierung, wobei das erwünschte Muster intakt bleibt.

Die bisherige Beschreibung betraf Ausführungsbeispiele, wo ein einzelner Strahl auf Gebiete der Vorderseite oder der Rückseite der Kathode fokussiert wird. Es liegt im Rahmen der Erfindung, auch mehrere Strahlen gleichzeitig zu benutzen und so an mehreren Stellen gleichzeitig zu plattieren.

Die in den nachstehenden speziellen Beispielen der Erfindung angegebenen Einzelheiten dienen der Erläuterung.

### Beispiel I

Als Kathode wird ein Substrat aus Glas verwendet mit einer darauf aufgedampften Schicht Nickel von etwa 1 000 Å Dicke. Der Elektrolyt hat die folgende Zusammensetzung :

```
21    g NiCl₂
25    g H₃BO₃
 1,64 g Na-Saccharinat (2 butyn, 1-4 diol)
auf 1    l mit H₂O aufgefüllt.
```

Eine Gleichspannung von 1,5 Volt wird an Kathode und Anode angelegt, während der Strahl eines Argonlasers auf die Kathode gerichtet wird, der einen Brennfleck mit 20 μm Durchmesser und einer Intensität von etwa $2 \times 10^5$ W/cm² ergibt. Durch periodisches Schwenken eines Spiegels im Lichtweg wird der Brennfleck mit einer Geschwindigkeit von 1 mm/s bewegt, was eine effektive Belichtungszeit für die Kathode von 20 μs ergibt. Mit diesen Parametern wird ein Leitungszug erzeugt mit einer Breite von 10 µm und einer Dicke zwischen 0,2 und 0,4 µm.

## Beispiel II

Als Kathode wird ein Substrat aus Glas verwendet, auf dem etwa 1 000 Å Wolfram aufgedampft ist. Die Strahlungsquelle, der Elektrolyt und die anderen Parameter sind gleich wie in Beispiel I. Der Durchmesser des Brennflecks wird auf etwa die Hälfte reduziert, was eine vierfache Intensität der Strahlung ergibt. Der Laserstrahl wird durch einen mechanischen Zerhacker periodisch unterbrochen. Ein Lichtimpuls von etwa 0,3 ms ermöglicht das Niederschlagen eines Metallflecks von 4 µm Durchmesser und etwa 0,05 µm Dicke.

## Beispiel III

Die Strahlungsquelle, der Elektrolyt, die Kathode und die angelegte Spannung sind gleich wie im Beispiel II. Der Laser wird fokussiert wie im Beispiel I beschrieben, der Brennfleck wird jedoch nicht über die Kathodenoberfläche bewegt. Mit zunehmender Belichtungszeit wächst auch die Dicke und der Durchmesser des durch die Laserstrahlung begünstigten Niederschlags an Nickel, wie aus der folgenden Tabelle ersichtlich ist :

| Dicke (µm) | Zeit (s) | Durchmesser (µm) |
|---|---|---|
| 6 | 1 | 30 |
| 5 | 1 | 30 |
| 9,5 | 2 | 35 |
| 9,5 | 2 | 35 |
| 12 | 4 | 40 |
| 12 | 4 | 40 |
| 14 | 8 | 45 |

Aus der Tabelle kann man ersehen, dass die Auflösung der Plattierung, wie man aus dem Durchmesser des Metallflecks entnehmen kann, mit zunehmender Belichtungszeit schlechter wird.

In allen diesen Fällen war die Dicke der Hintergrundplattierung unter 200 Å, woraus man entnehmen kann, dass die Laserstrahlung die Niederschlagsrate um drei Grössenordnungen steigert.

Durch Vergleich dieser Resultate mit den Beispielen I und II kann man ferner sehen, dass die Auflösung besser wird, wenn die Strahlungsquelle gepulst wird. Es ist zu beachten, dass der Durchmesser des Flecks kleiner wird, wenn die Belichtungszeit abnimmt.

## Beispiel IV

Als Kathode wird ein Substrat aus Glas verwendet, auf dessen Oberfläche zwei Leitungszüge aus Wolfram aufgedampft sind, deren Zwischenraum etwa 50 µm beträgt. Der Elektrolyt und die übrigen Arbeitsbedingungen sind praktisch die gleichen wie im Beispiel I mit Ausnahme der Abmessungen des Laserstrahls. In diesem Falle wird der Brennfleck der Laserstrahlung so bewegt, dass er sich zwischen den beiden Leitungszügen aus Wolfram hin und her bewegt und dabei den Niederschlag einer Leitung aus Nickel veranlasst, der die beiden Leitungszüge aus Wolfram elektrisch miteinander verbindet. Nach dieser Verbindung besteht eine Impedanz von einigen Ohm im Vergleich zur Impedanz von $3 \times 10^3$ Ohm vor dieser Verbindung. Dieses Verfahren kann benutzt werden, um integrierte Schaltungen zu verändern.

## Beispiel V

Es wird eine Kathode benutzt, wie im Beispiel I beschrieben. Der verwendete Elektrolyt hat folgende Zusammensetzung :

200 g $CuSO_4 \cdot 5H_2O$
50 g $H_2SO_4$ (konzentriert)
1 l $H_2O$

Eine Galvanisierungsspannung von 1 Volt wird angelegt. Ein Argonlaser wird verwendet, dessen Strahl auf einen Durchmesser von 150 µm fokusiert wird, der den Elektrolyten durchläuft. Der Strahl erzeugt einen Brennfleck von etwa 140 µm Durchmesser auf der Kathode. Die erhaltene Energiedichte des Strahles beträgt etwa $10^4$ W/cm$^2$ und die Belichtungszeit ist 20 Sekunden. Unter diesen Arbeitsbedingungen wird ein Fleck aus Kupfer auf dem Nickel niedergeschlagen, der 6 µm dick ist und dessen

**0 018 500**

Durchmesser 140 μm beträgt. Keine Hintergrundplattierung wird beobachtet.

Beispiel VI

Die Kathode, der Elektrolyt, der Laser und der Fleckdurchmesser sind gleich wie im Beispiel V beschrieben. Der Brennfleck wird jedoch jetzt über eine Linie von 5 mm mit einer Frequenz von 3 Zyklen je Sekunde 10 Sekunden lang hin und her geführt. Das ergibt eine totale effektive Belichtungszeit von 0,3 Sekunden. Der erhaltene Leitungszug ist 150 μm breit und 0,56 μm dick. Wie im Beispiel V erfolgt der Niederschlag nur in den belichteten Gebieten.

Beispiel VII

Als Kathode wird ein Substrat aus Glas verwendet, auf dem etwa 1 000 Å Wolfram aufgedampft ist. Der benutzte Elektrolyt hat folgende Zusammensetzung :

5,7-12,3 g/l Gold
saure Lösung von Goldzyanid
PH eingestellt auf 4,2-4,5

Eine Gleichspannung von 1,5 Volt wird an Kathode und Anode angelegt. Ein Argonlaser ist so fokussiert, dass sein Strahl durch das Substrat aus Glas hindurch geht, um auf die Wolframschicht zu treffen. Ein Brennfleck von etwa 300 μm Durchmesser und einer Intensität von $1 \times 10^3$ W/cm² wird gebraucht, um den Wolframfilm zu belichten. Mit zunehmender Belichtungszeit steigert sich die Dicke des durch die Laserstrahlung geförderten Niederschlages an Gold, wie aus der folgenden Tabelle ersichtlich ist.

| Dicke (Å) | Zeit (s) | Durchmesser (μm) |
|---|---|---|
| 800 | 2 | 300 |
| 1000 | 3 | 300 |
| 1200 | 3 | 400 |
| 3000 | 6 | 400 |
| 3600 | 6 | 500 |

Durch Vergleich der Ergebnisse der Beispiele III und VII kann man ersehen, dass die Niederschlagsrate eine Funktion der Energiedichte des Strahles ist. Um eine befriedigende Verbesserung zu erhalten, wird vorgeschlagen, Energiedichten von mindestens $1 \times 10^2$ W/cm² zu verwenden.

Das beschriebene Galvanisierverfahren nach der Erfindung ist für solche Anwendungen gut geeignet, wo Gebiete mit bevorzugtem Niederschlag wünschenswert sind. Mit diesem Verfahren kann man Leitungszüge auf Chips aufbringen, wie sie in integrierten Schaltungen gebraucht werden. Man kann daher integrierte Schaltungen auf den Chips verändern oder reparieren. Auch kann man das Verfahren in solchen Fällen anwenden, wo feine Leitungszüge aufgebracht werden müssen wie beispielsweise in Gasentladungstafeln für die Darstellung von Daten.

**Ansprüche**

1. Galvanisierverfahren mit selektiver Steigerung der Niederschlagsrate in ausgewählten Gebieten der Oberfläche einer Kathode, in dem man die Kathode und eine getrennte Anode in einen Elektrolyten einbringt, dadurch gekennzeichnet, dass man gebündelte elektromagnetische Strahlung auf die ausgewählten Gebiete der Oberfläche der Kathode richtet, während eine elektrische Spannung zwischen der Anode und der Kathode angelegt wird, wobei diese Gebiete selektiv aufgeheizt und bevorzugt plattiert werden, und daß das Verfahren so durchgeführt wird, daß die Strahlung wenig durch den Elektrolyten absorbiert wird.

2. Verfahren nach Anspruch 1, dadurch gekennzeichnet, dass man eine Kathode (14) verwendet, die aus einem schlecht wärmeleitenden Dielektrikum als Substrat (16) besteht, dessen Oberfläche (18) mit einer dünnen Metallschicht (19) elektrisch leitend gemacht ist.

3. Verfahren nach Anspruch 2, dadurch gekennzeichnet, dass das Material der genannten dünnen Metallschicht aus der Gruppe Wolfram, Molybdän, Nickel und Kupfer gewählt ist und dass die Dicke der Schicht zwischen 200 Å und 10 000 Å liegt.

4. Verfahren nach Anspruch 1, dadurch gekennzeichnet, dass die elektromagnetische Strahlung durch einen Laser erzeugt wird und dass der Brennfleck des Strahls auf der Kathode eine Energiedichte im Bereich von $10^2$ W/cm² bis $10^6$ W/cm² hat.

6

5. Verfahren nach Anspruch 4, dadurch gekennzeichnet, dass der Laserstrahl moduliert wird.

6. Verfahren nach Anspruch 5, dadurch gekennzeichnet, dass die Galvanisierspannung synchron mit der Laserstrahlung moduliert wird.

7. Verfahren nach Anspruch 1, dadurch gekennzeichnet, dass ein Elektrolyt verwendet wird, der Metallionen aus der Gruppe Gold, Nickel oder Kupfer enthält, die aus ihren Salzen geliefert werden.

8. Verfahren nach Anspruch 7, dadurch gekennzeichnet, dass die Metallionen aus der Gruppe Nickel und Kupfer gewählt sind, und dass der durch den Elektrolyten laufende Energiestrahl von einem Argonlaser erzeugt wird.

9. Verfahren nach Anspruch 7, dadurch gekennzeichnet, dass die Metallionen aus Gold bestehen, und dass der durch den Elektrolyten laufende Energiestrahl von einem Kryptonlaser erzeugt wird, der auf 6 471 Å abgestimmt ist.

10. Verfahren nach Anspruch 1, dadurch gekennzeichnet, dass man nach der Fertigstellung der Niederschläge in bevorzugten Gebieten der Kathode etwaig vorhandene schwache Hintergrundplattierung durch mildes Aetzen aus den übrigen Gebieten entfernt.

## Claims

1. Plating method with a selective increase of the plating rate at selected regions of the surface of a cathode, in which the cathode and a separate anode are placed in an electrolyte, characterized in that a focussed beam of electromagnetic energy is directed at the selected regions of the surface of the cathode while an electric potential is applied between the anode and the cathode, whereby said regions are selectively heated and preferentially plated, and that the method is carried out such that the beam is little absorbed by the electrolyte.

2. A method as claimed in claim 1, characterized in that a cathode (14) is chosen consisting of a thermally insulating substrate (16) the surface (18) of which is rendered electrically conducting by a thin metallic layer (19).

3. A method as claimed in claim 2, characterized in that the material of the thin metallic layer is chosen from the group consisting of tungsten, molybdenum, nickel or copper and that the thickness of the layer is between 200 Å and 10,000 Å.

4. A method as claimed in claim 1, characterized in that the beam of electromagnetic energy is generated by a laser and that the intensity of the beam focus at the cathode is between $10^2$ W/cm$^2$ to $10^6$ W/cm$^2$.

5. A method as claimed in claim 4, characterized in that the laserbeam is modulated.

6. A method as claimed in claim 5, characterized in that the applied electric potential is modulated in synchronism with the laserbeam.

7. A method as claimed in claim 1, characterized in that an electrolyte is chosen to contain metallic ions from the group consisting of gold, nickel, or copper which are provided from their salts.

8. A method as claimed in claim 7, characterized in that the metallic ions are selected from the group consisting of nickel and copper and that the beam passing through the electrolyte is generated by an argon laser.

9. A method as claimed in claim 7, characterized in that the metallic ions consist of gold and that the beam passing through the electrolyte is generated by a krypton laser tuned to 6,471 Å.

10. A method as claimed in claim 1, characterized in that, after completion of the plating at selected regions of the cathode, the other regions are slightly etched to remove any possible background plating.

## Revendications

1. Procédé de galvanisation avec augmentation sélective de la vitesse de dépôt dans des zones choisies de la surface d'une cathode en immergeant ladite cathode et une anode distincte dans un électrolyte, caractérisé en ce qu'on dirige à un faisceau de rayonnement électromagnétique sur lesdites zones choisies de la surface de la cathode, tandis qu'une tension électrique est appliquée entre l'anode et la cathode, où lesdites régions sont sélectivement chauffées et de préférence plaquées, et en ce que ledit procédé de galvanisation est exécuté de telle sorte que l'absorption du rayonnement par l'électrolyte est faible.

2. Procédé selon la revendication 1, caractérisé en ce qu'on utilise une cathode (14) ayant comme substrat (16) un diélectrique de faible conductibilité thermique, et dont la surface (18) est devenue conductrice électriquement grâce à une couche métallique fine (19).

3. Procédé selon la revendication 2, caractérisé en ce que le matériau constituant ladite couche métallique fine est choisi parmi le groupe de tungstène, molybdène, nickel, ou cuivre, et en ce que son épaisseur est comprise entre 200 Å et 10 000 Å.

4. Procédé selon la revendication 1, caractérisé en ce que le rayonnement électromagnétique est un rayon laser et en ce que la dénsité du flux d'énergie émis par le foyer du rayon sur la cathode a une valeur comprise entre $10^2$ W/cm$^2$ et $10^6$ W/cm$^2$.

5. Procédé selon la revendication 4, caractérisé en ce que le rayon laser est modulé.

6. Procédé selon la revendication 5, caractérisé en ce que la tension de galvanisation est modulée en synchronisme avec le rayon laser.

7. Procédé selon la revendication 1, caractérisé en ce qu'on utilise un électrolyte contenant des ions métalliques, des radicaux or, nickel ou cuivre une fois séparés de leurs sels.

8. Procédé selon la revendication 7, caractérisé en ce qu'on choisit des ions métalliques appartenant aux radicaux nickel et cuivre, et en ce que le rayon laser appliqué audit électrolyte est un rayon laser à argon.

9. Procédé selon la revendication 7, caractérisé en ce qu'on utilise des ions métalliques extraits de l'or, et en ce que le rayon laser appliqué audit électrolyte est un rayon laser au krypton de 6 471 Å.

10. Procédé selon la revendication 1, caractérisé en ce qu'une fois le dépôt effectué sur les régions préférées de la cathode, les quelques plaques subsistant dans les autres régions sont enlevées par une opération de décapage doux.

FIG. 1

FIG. 2